# EUROPEAN PATENT APPLICATION

(11) **EP 1 429 389 A1**
(43) Date of publication of application: **16.06.2004**
(21) Application number: 03257807.2
(22) Date of filing: 11.12.2003
(51) Int. Cl.: H01L 25/065, H01L 25/16, H01L 23/31

(54) **Compact circuit module having high mounting accuracy and method of manufacturing the same**

(30) Priority: 12.12.2002 JP 2002360705
(71) Applicant: ALPS ELECTRIC CO., LTD., Ota-ku Tokyo 145 (JP)
(72) Inventor: Hirose, Yoshitaka, Ota-ku, Tokyo 145 (JP)
(74) Representative: Kensett, John Hinton

(57) **Abstract**

In a circuit module, an insulation layer (10) is formed on a first (1a) or second (1b) surface of a circuit substrate (1) such that it substantially entirely covers the first or second surface, and a first or second flip chip component (4, 6) is embedded in the insulation layer. Since the first and second flip chip components are thus distributed on the first and second surfaces of the circuit substrate, a reduction in size can be achieved. The flip chip component located on the side opposite to the embedded flip chip component can be mounted using an exposed surface of the insulation layer as a datum. The mounting position can therefore be accurate to allow mounting with high accuracy.

## Description

### BACKGROUND OF THE INVENTION

### 1. Field of the Invention

The present invention relates to a circuit module which is suitable for use in a short range wireless apparatus and a method of manufacturing the same.

### 2. Description of Related Art

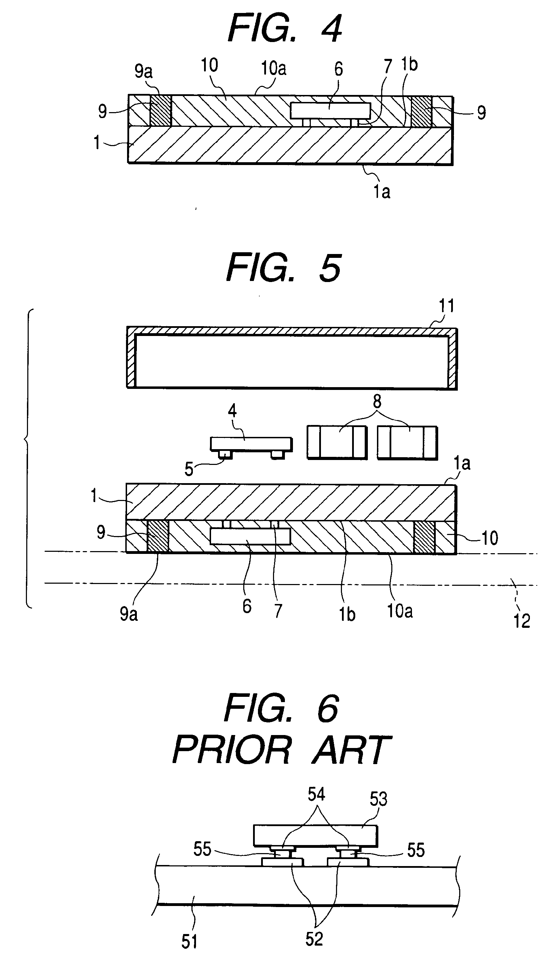

A configuration of a circuit module according to the related art will be described with reference to Fig. 6. A wiring pattern 52 is formed on a surface of a circuit substrate 51 which is constituted by a single insulated substrate or a plurality of the insulated substrates stacked one over another.

A flip chip component (semiconductor chip) 53 constituted by a bare semiconductor chip has bumps 55 that are secured to electrodes 54 on the bottom thereof, and a plurality of the flip chip components 53 is mounted on the circuit substrate 51 with the bumps 55 thereof mounted on the wiring pattern 52.

Referring to the wiring pattern 52 on the circuit substrate 51, various electrical components (not shown) are soldered to the wiring pattern 52 to mount the electrical components on the circuit substrate 51 and to thereby form a desired electrical circuit on the same (for example, see Patent Document 1).

When the flip chip components 53 and the electrical components are thus mounted on the surface that is one side of the circuit substrate 51, the circuit substrate 51 has a large surface area which goes against reduction in size.

A possible solution is to distribute at least the flip chip components 53 on both sides of the circuit substrate 51. In this manufacturing method, a first flip chip component 53 can be mounted on one side of the circuit substrate 51 with high mounting accuracy because a flat surface on the other side of the circuit substrate 51 serves as a datum when the first flip chip component 53 is mounted on the one side of the circuit substrate 51.

However, when a second flip chip component 53 is mounted on the other side of the circuit substrate 51, the one side of the circuit substrate 51 is placed on a jig (not shown) with the first flip chip component 53 located on the bottom thereof. In this case, the jig has a complicated configuration provided with a portion to clear the first flip chip component 53 and, furthermore, it is expected that the support of the circuit substrate 51 will become unstable. Thus, variations occur in the mounting of the second flip chip component 53 to reduce mounting accuracy.

Referring to the jig, there is a need for preparing various jigs adapted to the configurations of various circuit modules, which results in a cost increase.

Patent Document: Japanese Unexamined Published Patent Application No. 2001-60602

In the circuit module according to the related art, since the flip chip components 53 and electrical components are mounted on a surface that is one side of the circuit substrate 51, a problem arises in that the module is large-sized because the circuit substrate 51 thus has a large surface area.

Although at least the flip chip components 53 may be distributed on both sides of the circuit substrate 51, the jigs are complicated and are to be prepared in a great number in this case, which results in a cost increase and in a problem in that the flip chip components 53 cannot be mounted with high accuracy.

It is therefore an object of the invention to provide a circuit module which is compact, on which flip chip components can be mounted with high accuracy, and which is inexpensive and to provide a method of manufacturing the same.

### SUMMARY OF THE INVENTION

To solve the above-described problem, in a first aspect of the invention, there is provided a circuit substrate having a first wiring pattern provided on a first surface on one side thereof and a second wiring pattern provided on a second surface on another side thereof, a first flip chip component mounted on the first surface, and a second flip chip component mounted on the second surface, and a configuration is employed in which an insulation layer is formed on the first or second surface such that it substantially entirely covers the first or second surface and in which the first or second flip chip component is embedded in the insulation layer.

Preferably, an exposed surface of the insulation layer is a flat surface that is in parallel with the first or second surface.

Preferably, an electrical component is mounted on the first surface in addition to the first flip chip component and in which the flip chip component mounted on the second surface is embedded in the insulation layer.

Preferably, a terminal portion is formed on the second surface in a state in which it is connected to the second wiring pattern and in which the terminal portion is embedded in the insulation layer with an end face thereof exposed.

Preferably, the terminal portion can be connected to a conductive pattern on a mother substrate with a surface of the insulation layer placed on the mother substrate.

In another aspect of the invention, a manufacturing method is employed which includes the steps of: providing a circuit substrate having a first wiring pattern provided on a first surface on one side thereof and a second wiring pattern provided on a second surface on another side thereof, a first flip chip component mounted on the first surface, and a second flip chip component mounted on the second surface; forming an insulation layer such that it substantially entirely covers the second surface after the second flip chip component is mounted on the second surface, the second flip chip component being embedded therein; and mounting the first flip chip component on the first surface using the insulation layer as a datum.

Preferably, the insulation layer is formed by injection-molding or applying a material.

Preferably, an exposed surface of the insulation layer is polished or cut to make the exposed surface of the insulation layer into a flat surface that is in parallel with the second surface.

Preferably, a terminal portion is formed on the second surface and in which the terminal portion is embedded in the insulation layer with an end face of the terminal portion exposed.

Embodiments of the invention will now be described, by way of example only, with reference to the accompanying drawings, in which:
Fig. 1 is a sectional view of a major part of a circuit module according to the invention;
Fig. 2 is an illustration of a first step according to a method of manufacturing the circuit module of the invention;
Fig. 3 is an illustration of a second step according to the method of manufacturing the circuit module of the invention;
Fig. 4 is an illustration of a third step according to the method of manufacturing the circuit module of the invention;
Fig. 5 is an illustration of a fourth step according to the method of manufacturing the circuit module of the invention; and
Fig. 6 is a front view of a circuit module according to the related art.

### DESCRIPTION OF THE PREFERRED EMBODIMENT

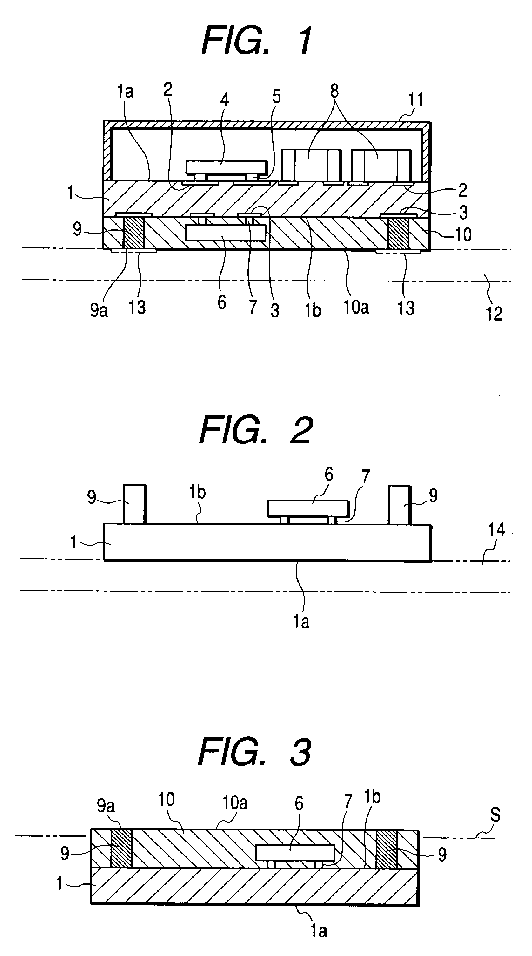

Referring to drawings of a circuit module and a method of manufacturing the same according to the invention: Fig. 1 is a sectional view of a major part of a circuit module according to the invention; Fig. 2 is an illustration of a first step according to a method of manufacturing the circuit module of the invention; Fig. 3 is an illustration of a second step according to the method of manufacturing the circuit module of the invention; Fig. 4 is an illustration of a third step according to the method of manufacturing the circuit module of the invention; and Fig. 5 is an illustration of a fourth step according to the method of manufacturing the circuit module of the invention.

A configuration of the circuit module of the invention will now be described with reference to Fig. 1. A circuit substrate 1 constituted by a single insulated substrate or a plurality of the insulated substrates stacked one over another has a first wiring pattern 2 constituted by a conductive pattern provided on a first surface 1a on one side thereof and a second wiring pattern 3 constituted by a conductive pattern provided on a second surface 1b on another side thereof.

The first wiring pattern 2 on the first surface 1a (top surface) and the second wiring pattern 3 on the second surface 1b (bottom surface) are connected to each other by a connection conductor and the like (not shown) along with conductors and the like provided in the circuit substrate 1.

A first flip chip component (semiconductor chip) 4 constituted by a bare semiconductor chip is connected to the first wiring pattern 2 by connecting portions 5 constituted by bumps or wires, and the first flip chip component 4 is thus mounted on the circuit substrate 1.

A second flip chip component (semiconductor chip) 6 constituted by a bare semiconductor chip is connected to the second wiring pattern 3 by connecting portions 7 constituted by bumps or wires, and the second flip chip component 6 is thus mounted on the circuit substrate 1.

Various electrical components 8 such as resistors and capacitors are soldered to the first wiring pattern 2 on the first surface 1a of the circuit substrate 1, and the electrical components 8 are thus mounted on the circuit substrate 1 to form a desired electrical circuit that constitutes a circuit module.

A plurality of columnar terminal portions 9 constituted by solder bumps are provided on the second wiring pattern 3 on the second surface 1b of the circuit substrate 1 along a peripheral section of the circuit substrate 1, and the terminal portions 9 protrude downward from the second surface 1b.

An insulation layer 10 made of an insulating material such as a synthetic resin is formed on the second surface 1b such that it substantially entirely covers the second surface 1b and such that the second flip chip component 6 and the terminal portions 9 are embedded therein.

The insulation layer 10 is formed by injection-molding or applying the insulating material, and an exposed surface 10a of the insulation layer 10 is polished or cut into a flat surface that is in parallel with the second surface 1b.

End faces 9a of the terminal portions 9 embedded in the insulation layer 10 are exposed on the insulation layer 10.

A box-like cover 11 constituted by a metal plate is mounted on the first surface 1a so as to cover the first flip chip component 4 and the electrical components 8, thereby electrically shielding the electrical circuit. The circuit module according to the invention is formed in such a configuration.

The circuit module according to the invention having such a configuration is assembled on to a mother substrate 12 by placing the insulation layer 10 on the mother substrate 12 and soldering the end faces 9a of the terminal portions 9 to a conductive pattern 13 on the mother substrate 12.

Although in this embodiment the second surface 1b is covered by the insulation layer 10, the first surface 1a may alternatively be covered by the insulation layer 10. Further, electrical components 8 may be provided also on the second surface 1b.

A method of manufacturing the circuit module according to the invention will now be described with reference to Figs. 2 to 5. First, at a first step, as shown in Fig. 2, the second flip chip component 6 is mounted on the second wiring pattern 3 and the terminal portions 9 are formed on the second wiring pattern 3 with the first surface 1a of the circuit substrate 1 placed on a flat surface of a jig 14.

At this time, the circuit substrate 1 is stably supported on the jig 14, and the mounting position of the second flip chip component 6 is accurate to allow mounting with high accuracy.

Next, as a second step, the insulation layer 10 is formed such that it substantially entirely covers the second surface 1b as shown in Fig. 3. The second flip chip component 6 is embedded in the insulation layer 10, and the terminal portions 9 are also embedded with the end faces 9a exposed.

Next, as a third step, polishing or cutting is performed to cut the surface of the insulation layer 10 and the tops of the terminal portions 9 down to the line S shown in Fig. 3, thereby processing the exposed surface 10a of the insulation layer 10 into a flat surface that is in parallel with the second surface 1b as shown in Fig. 4.

Next, as a fourth step, as shown in Fig. 5, the first flip chip component 4, the electrical components 8, and the cover 11 are sequentially mounted on the first surface 1a with the exposed surface 10a of the insulation layer 10 placed on the flat surface of the jig 14, which completes the manufacture of the circuit module.

The circuit substrate 1 is securely supported because the insulation layer 10 is placed on the jig 14, and the first flip chip component 4 and the electrical components 8 are mounted using the flat exposed surface 10a of the insulation layer 10 as a datum. Their mounting positions are therefore accurate to allow mounting with high accuracy.

A circuit module according to the invention includes a circuit substrate having a first wiring pattern provided on a first surface on one side thereof and a second wiring pattern provided on a second surface on another side thereof, a first flip chip component mounted on the first surface and a second flip chip component mounted on the second surface. It has a configuration in which an insulation layer is formed on the first or second surface such that it substantially entirely covers the first or second surface and in which the first or second flip chip component is embedded in the insulation layer.

Such a configuration makes it possible to provide a circuit module with a small size because at least the first and second flip chip components are distributed on the first and second surfaces of the circuit substrate.

Since one side of the circuit substrate is substantially entirely covered by the insulation layer and one of the flip chip components is embedded in the insulation layer, the other flip chip component can be mounted using the exposed surface of the insulation layer as a datum. Therefore, the mounting position of the other flip chip component is made accurate to allow mounting with high accuracy.

The jig on which the insulation layer is placed is simplified in configuration and can be provided at a low cost.

Further, since the exposed surface of the insulation layer is made into a flat surface that is in parallel with the first or second surface, the mounting position of the other flip chip component is made more accurate to allow mounting with higher accuracy.

The electrical components are mounted on the first surface in addition to the first flip chip component, and the flip chip component mounted on the second surface is embedded in the insulation layer. As a result, the electrical components can be mounted using the insulation layer as a datum to obtain accurate mounting positions of the electrical components.

Terminal portions are formed on the second surface in a state in which they are connected to the second wiring pattern, and the terminal portions are embedded in the insulation layer with their end faces exposed. As a result, since the terminal portions to be used for external connections do not interpose an obstacle to the placement of the insulation layer on a jig, the mounting positions of the flip chip components and the electrical components are accurate, and mounting can be performed with high accuracy.

The terminal portions can be connected to the conductive pattern on the mother substrate with the surface of the insulation layer placed on the mother substrate. As a result, the flatness of the region of the terminal portions is improved, and the circuit module is placed on the mother substrate with stability, which makes it possible to provide a circuit module that can be solder-jointed with high reliability.

A manufacturing method can be provided which includes the steps of: providing a circuit substrate having a first wiring pattern provided on a first surface on one side thereof and a second wiring pattern provided on a second surface on another side thereof, a first flip chip component mounted on the first surface, and a second flip chip component mounted on the second surface; forming an insulation layer such that it substantially entirely covers the second surface after the second flip chip component is mounted on the second surface, the second flip chip component being embedded therein; and mounting the first flip chip component on the first surface using the insulation layer as a datum. Therefore, the first flip chip can be mounted using the exposed surface of the insulation layer as a datum, whereby the mounting position of the first flip chip component is made accurate to allow mounting with high accuracy, and a jig can be simple in configuration and inexpensive.

Since the insulation layer is formed by injection-molding or applying a material, the insulation layer can be formed easily.

An exposed surface of the insulation layer is polished or cut to make the exposed surface of the insulation layer into a flat surface that is in parallel with the second surface. Since this simplifies the processing of the exposed surface and makes the mounting position of the first flip chip component more accurate, mounting can be carried out with higher accuracy.

Terminal portions are formed on the second surface, and the terminal portions are embedded in the insulation layer with end faces of the terminal portions exposed. Therefore, the terminal portions can be embedded in the insulation layer simultaneously with the second flip chip component, and the terminal portions to be used for external connection do no interpose an obstacle to the placement of the insulation layer on the jig. The mounting positions of the first flip chip component and the electrical components are therefore accurate to allow mounting with high accuracy.

## Claims

1. A circuit module comprising:
a circuit substrate having a first wiring pattern provided on a first surface on one side thereof and a second wiring pattern provided on a second surface on another side thereof;
a first flip chip component mounted on the first surface; and
a second flip chip component mounted on the second surface, wherein an insulation layer is formed on the first or second surface such that it substantially entirely covers the first or second surface and wherein the first or second flip chip component is embedded in the insulation layer.

2. A circuit module according to Claim 1, wherein an exposed surface of the insulation layer is a flat surface that is in parallel with the first or second surface.

3. A circuit module according to Claim 1 or 2, wherein an electrical component is mounted on the first surface in addition to the first flip chip component and wherein the flip chip component mounted on the second surface is embedded in the insulation layer.

4. A circuit module according to Claim 1, 2 or 3, wherein a terminal portion is formed on the second surface in a state in which it is connected to the second wiring pattern and wherein the terminal portion is embedded in the insulation layer with an end face thereof exposed.

5. A circuit module according to Claim 4, wherein the terminal portion can be connected to a conductive pattern on a mother substrate with a surface of the insulation layer placed on the mother substrate.

6. A method of manufacturing a circuit module, comprising the steps of:
providing a circuit substrate having a first wiring pattern provided on a first surface on one side thereof and a second wiring pattern provided on a second surface on another side thereof, a first flip chip component mounted on the first surface, and a second flip chip component mounted on the second surface;
forming an insulation layer such that it substantially entirely covers the second surface after the second flip chip component is mounted on the second surface, the second flip chip component being embedded therein; and
mounting the first flip chip component on the first surface using the insulation layer as a datum.

7. A method of manufacturing a circuit module according to Claim 6, wherein the insulation layer is formed by injection-molding or applying a material.

8. A method of manufacturing a circuit module according to Claim 6 or 7, wherein an exposed surface of the insulation layer is polished or cut to make the exposed surface of the insulation layer into a flat surface that is in parallel with the second surface.

9. A method of manufacturing a circuit module according to Claim 6, 7 or 8, wherein a terminal portion is formed on the second surface and wherein the terminal portion is embedded in the insulation layer with an end face of the terminal portion exposed.
